# EUROPEAN PATENT APPLICATION

(11) **EP 2 141 976 A2**
(43) Date of publication of application: **06.01.2010**
(21) Application number: 09161617.7
(22) Date of filing: 01.06.2009
(51) Int. Cl.: H05K 9/00

(54) **Enclosure**

(30) Priority: 01.07.2008 JP 2008171994
(71) Applicant: Fujitsu Ltd., Kawasaki-shi, Kanagawa 211-8588 (JP)
(72) Inventor: Yui, Yasushi, Kawasaki-shi Kanagawa 211-8588 (JP)
(74) Representative: Fenlon, Christine Lesley

(57) **Abstract**

An enclosure includes a main body, a metal plate, an adhesive agent and a metal-plated film. The main body is formed of resin material. The metal plate covers the back surface of the main body. The adhesive agent is provided between the main body and the metal plate. The metal-plated film is formed on the front surface of the main body and electrically connected to the metal plate.

## Description

### CROSS-REFERENCE TO RELATED APPLICATION

This application is based upon and claims the benefit of priority of the prior Japanese Patent Application No. 2008-171994, filed on July 1, 2008, the entire contents of which are incorporated herein by reference.

### FIELD

The present invention relates to an enclosure.

### BACKGROUND

An enclosure of a mobile terminal is formed of resin material such as ABS (acrylonitrile-butadiene-styrene) resin, polycarbonate resin or the like. Various components such as a mother board are installed in the enclosure (see, for example, Japanese Laid-open Patent Publication 2001-315159, Japanese Laid-open Patent Publication 2007-215621 and Japanese Laid-open Patent Publication 2003-54645).

As performance of electronic devices have recently enhanced, and high integration on the mother board has also improved, electromagnetic waves are generated from electronic components, and leak out of the enclosure. In addition, external noise intrudes into the enclosure. Accordingly, it is desirable to improve the shield performance of the enclosure.

### SUMMARY

According to an aspect of an embodiment of the present invention, an enclosure includes: a main body that is formed of resin material; a metal plate that covers the back surface of the main body; an adhesive agent that is provided between the main body and the metal plate; and a metal-plated film that is formed on the front surface of the main body and electrically connected to the metal plate.

It is to be understood that both the foregoing general description and the following detailed description are exemplary, and are not restrictive of the invention, as claimed.

### BRIEF DESCRIPTION OF DRAWINGS

The above and other desirable outcomes, features and advantages of embodiments of the present invention will become apparent from the following description of the preferred embodiments in conjunction with the accompanying drawings, wherein:
Fig. 1 is a perspective view illustrating the outlook of a mobile terminal according to a first embodiment of the present invention;
Fig. 2 is a perspective view illustrating the structure of an enclosure according to the first embodiment;
Fig. 3 is a cross-sectional view taken along a line 3-3 of Fig. 2;
Fig. 4 is a schematic view illustrating a metal plate according to the first embodiment is disposed in a mold;
Fig. 5 is a cross-sectional view illustrating an enclosure according to a second embodiment of the present invention;
Fig. 6 is a cross-sectional view illustrating an enclosure according to a third embodiment of the present invention; and
Fig. 7 is a cross-sectional view illustrating an enclosure according to a fourth embodiment of the present invention.

### DESCRIPTION OF EMBODIMENTS

Embodiments of the present invention will be described hereinafter with reference to the accompanying drawings.

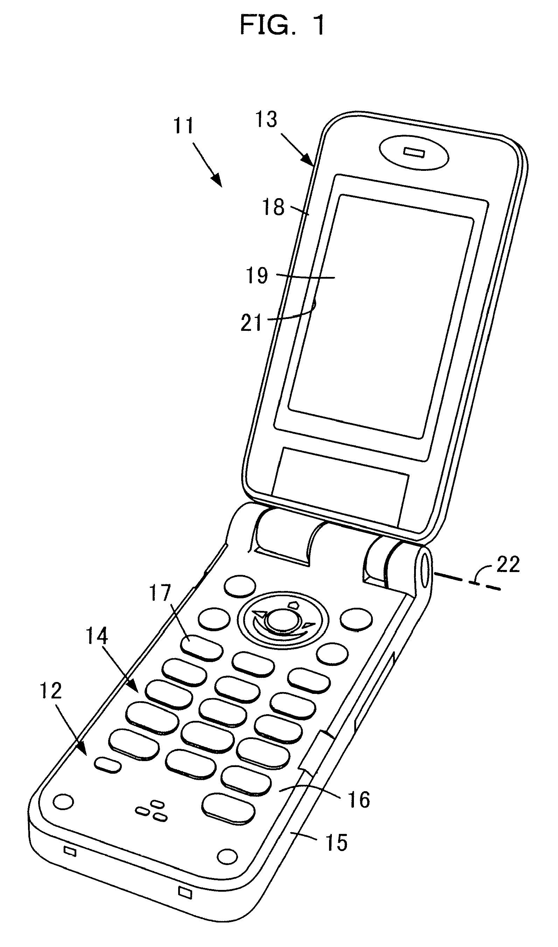

Fig. 1 schematically illustrates a mobile terminal 11 having a clamshell-shaped form as an example of electronic equipment. The mobile terminal 11 has a transmitter 12 and a receiver 13. The enclosure 14 of the transmitter 12 has a base 15 and a cover 16 which is detachably joined to the base 15. Input buttons 17 such as on-hook buttons, off-hook buttons, dial keys, etc. are provided on the flat surface of the cover 16.

A liquid crystal display (LCD) panel 19 as a flat display panel is mounted in the enclosure 18 of the receiver 13. A display opening 21 is provided on the front surface of the receiver enclosure 18. The screen of the LCD panel 19 faces the display opening 21. Various texts and graphics are displayed on the screen of the LCD panel 19 in accordance with the processing operation of a CPU(central processing unit). The receiver enclosure 18 may be formed of resin material, for example.

The receiver 13 may be swung around the horizontal axis 22 with respect to the transmitter 12. The horizontal axis 22 is set at one end of the transmitter enclosure 14 while being in parallel with the front surface of the transmitter enclosure 14. When the front surface of the receiver enclosure 18 is overlapped to the front surface of the transmitter enclosure 14, the mobile terminal 11 is closed, thereby establishing the folded state.

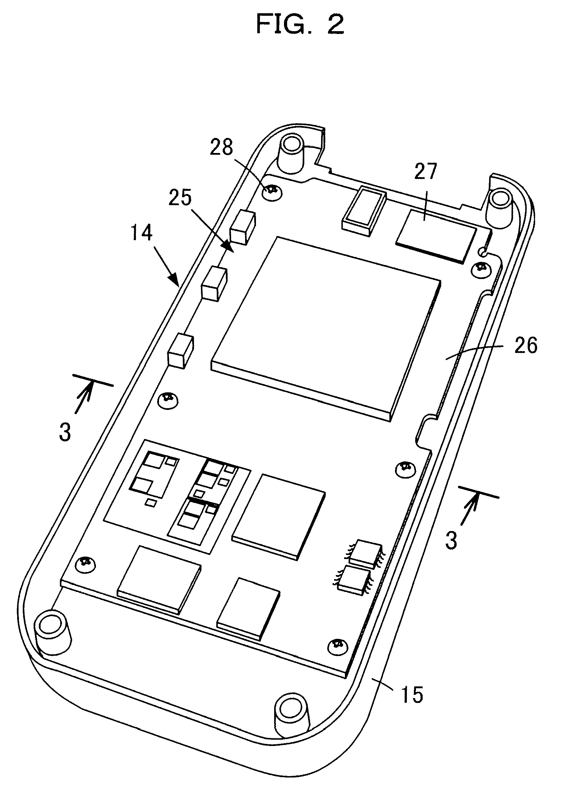

As depicted in Fig. 2, a printed circuit board unit 25 is mounted in the transmitter enclosure 14. The printed circuit board unit 25 has a printed circuit board 26 formed of resin, for example. A plurality of electronic components 27 such as a CPU chip, a memory, etc. are mounted on the surface of the printed circuit board 26. For example, the CPU chip executes various kinds of processing in accordance with an operation of the input button 17 as described above. The printed circuit board 26 is fixed to the base 15 of the transmitter enclosure 14 with a plurality of screws 28.

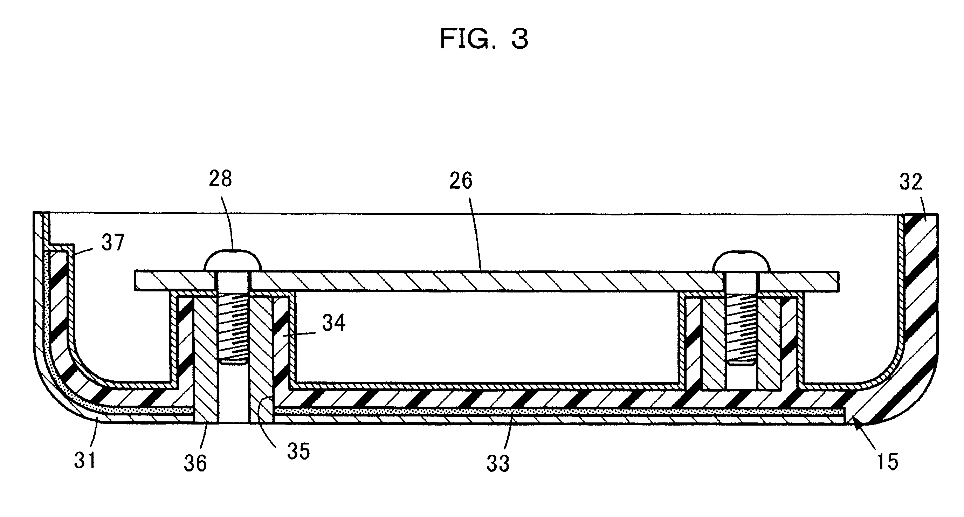

Fig. 3 schematically illustrates the cross-sectional view of the base 15 according to the first embodiment of the present invention. The base 15 has a metal plate 31 which is exposed to the outer surface of the transmitter enclosure 14. In the first embodiment, the metal plate 31 spreads over the bottom plate and one side surface of the base 15. The metal plate 31 may be formed of aluminum, copper, iron, nickel, chrome, cobalt, zinc, titanium, magnesium, tin, tungsten, carbon, boron, lead, gold, silver, platinum, platinum group metal or alloy of any metals described above. In the first embodiment, the metal plate 31 is formed of magnesium.

In the following description, a surface which faces the inner space of the base 15 in Figs. 3, 5 to 7 is defined as "front surface", and a surface which faces the outside of the base 15 is defined as "back surface". The base 15 has a main body 32 which covers on the metal plate 31 so that the front surface of the metal plate 31 is covered by the back surface of the main body 32. The main body 32 is attached to the metal plate 31. The main body 32 is exposed to the outer surface of the transmitter enclosure 14 over an area where the metal plate 31 is not attached to the main body 32. In the first embodiment, the main body 32 spreads over the bottom plate of the base 15 and both the side surfaces of the base 15. The main body 32 is formed of biodegradable resin. As the biodegradable resin, polylactic acid resin, acetyl cellulose resin, bioplastic, plant-based plastic, and other biodegradable resin materials may be used. In the first embodiment, the main body 32 is formed of polylactic resin.

The base 15 has adhesive agent 33 which is provided between the metal plate 31 and the main body 32. The adhesive agent 33 spreads all over the gap between the front surface of the metal plate 31 and the back surface of the main body 32. The back surface of the main body 32 is attached to the front surface of the metal plate 31 with the adhesive agent 33. Resin-based adhesive agent such as acrylic type, epoxy type, silicone type or the like may be used as the adhesive agent 33. The back surface of the main body 32 is strongly joined to the front surface of the metal plate 31 with high adhesion strength of the adhesive agent 33.

Cylindrical bosses 34, for example are provided on the front surface of the main body 32. At one of the bosses 34, a cylindrical space penetrates through the main body 32 and the metal plate 31, that is, a through hole 35 is formed. A metal insert member 36 is embedded in each of the through hole 35 and the other boss 34. The insert member 36 is pressed into the bosses 34. Each insert member 36 is internally threaded. The lower end of the insert member 36 is exposed to the outer surface of the transmitter enclosure 14, and thus the lower end of the insert member 36 is electrically connected to the metal plate 31.

The base 15 has a metal-plated film 37 formed on the front surface of the main body 32. The upper end of the insert members 36 is covered by the metal-plated film 37. The metal-plated film 37 may be formed of aluminum, copper, iron, nickel, chromium, cobalt, zinc, titan, magnesium, tin, tungsten, carbon, boron, lead, gold, silver, platinum, platinum group metal or alloy of these metal materials. In the first embodiment, the metal-plated film 37 is formed of aluminum.

As depicted in Fig. 3, the metal plate 31 is formed such that a portion of the metal plate 31 protrudes outside the main body 32 at one side of the base 15. As a result, a portion of the front surface of the metal plate 31 is exposed out of the main body 32, and the metal-plated film 37 is formed on the front surface of the exposed metal plate 31. The metal-plated film 37 extends from the front surface of the main body 32 to the front surface of the exposed metal plate 31. Accordingly, the metal-plated film 37 is electrically connected to the metal plate 31. At the same time, the metal-plated film 37 is electrically connected to the upper end of the insert members 36.

The printed circuit board 26 is fixed on the bosses 34. The screws 28 used to fix the printed circuit board 26 are screwed into the insert members 36. In the base 15, the insert member 36 is electrically connected to both the metal plate 31 and the metal-plated film 37. The screw 28 is screwed into the insert member 36, and thus the metal plate 31 and the metal-plated film 37 can function as a ground member. In the first embodiment, the insert member 36 may be regarded as "electrical conductive material" of the invention.

In the mobile terminal 11 as described above, the main body 32 is provided between the metal plate 31 and the metal-plated film 37. The mechanical strength of the base 15 is enhanced by the metal plate 31. In addition, the metal plate 31 and the metal-plated film 37 can function as a shield layer. Because the shield layer is broadly formed over the main body 32, the shield performance is enhanced in the transmitter enclosure 14. In addition, the metal-plated film 37 is in contact with the front surface of the exposed metal plate 31 at one side of the main body 32. At the same time, the metal-plated film 37 is electrically connected to the metal plate 31 through the insert member 36. Accordingly, the shield performance may be further enhanced. In addition, when the main body 32 is formed of biodegradable resin, the main body 32 may degrade in soil with ease, thereby preventing occurrence of waste materials. For example, as compared with burnout of petroleum resin materials, the carbon dioxide emissions of the biodegradable resin may be reduced by about 50 percent. Accordingly, environment deterioration can be prevented.

Next, a method of manufacturing the base 15 will be described.

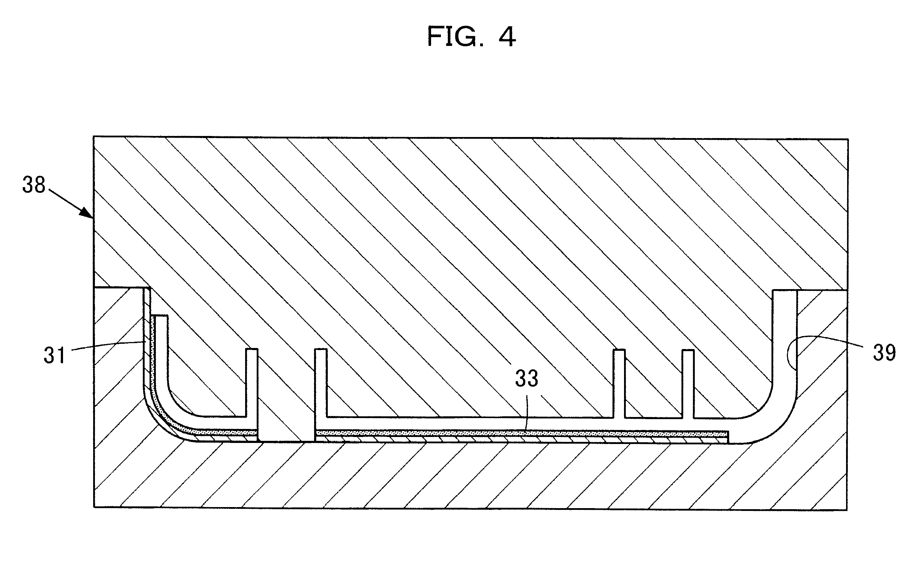

First, the metal plate 31 is formed. The planar metal plate is subjected to a bending work and a boring work. The adhesive agent 33 is applied on the surface of the metal plate 31. For example, the adhesive agent 33 may be sprayed or printed on the surface of the metal plate 31. As depicted in Fig. 4, the metal plate 31 is disposed in a cavity 39 of a mold, for example, a metal mold 38. Then, molten biodegradable resin material is poured into the cavity 39. The biodegradable resin material is cooled and hardened in the cavity 39. The main body 32 is formed through the hardening of the biodegradable resin material. The main body 32 is firmly fixed to the front surface of the metal plate 31 due to the adhesive agent 33. Then, the metal plate 31 and the main body 32 are taken out from the metal mold 38.

After the metal plate 31 and the main body 32 are taken out from the metal mold 38, the insert members 36 are pressed into the bosses 34 of the main body 32. Then, the front surface of the main body 32 is subjected to a plating treatment. The plating treatment may contain an electrolytic plating method, an electroless deposition method, a vapor deposition method, an ion plating method, a sputtering method or the like. The metal-plated film 37 is formed on the front surface of the main body 32 and the front surface of the exposed metal plate 31 by the plating treatment. As a result, the metal-plated film 37 extends from the front surface of the main body 32 to the front surface of the exposed metal plate 31 which is located at one portion outside of the main body 32. At the same time, the metal-plated film 37 covers the upper end of the insert members 36. Then, the screws 28 are screwed into the insert members 36 to fix the printed circuit board 26, and thus the base 15 is manufactured.

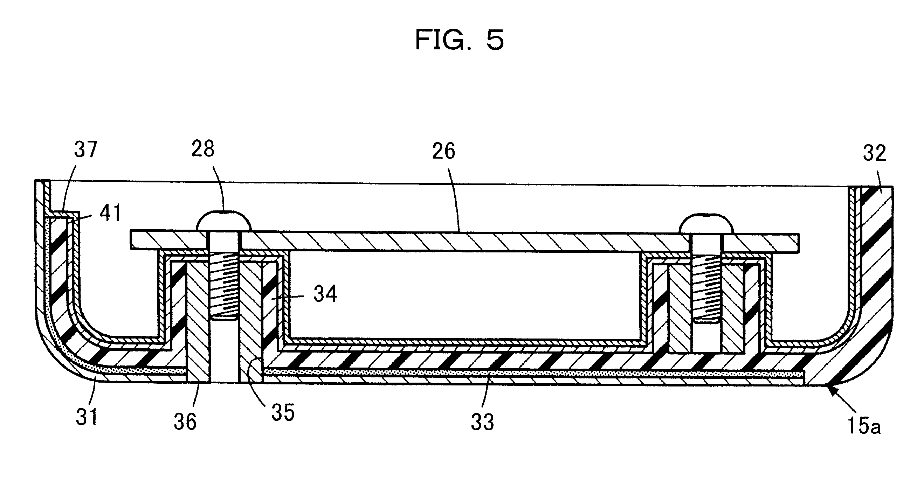

Fig. 5 schematically illustrates a cross-sectional view of a base 15a according to a second embodiment of the present invention. In the base 15a, a coating film 41 is provided between the main body 32 and the metal-plated film 37. The metal-plated film 37 is also formed on one end portion of the front surface of the metal plate 31 at one side surface of the main body 32. The coating film 41 is formed of primer coating compound of acrylic type, epoxy type, polyester type or urethane type. Other components or structures in the base 15a which is similar to the base 15 described above are represented by the same reference numerals. According to the base 15a of the second embodiment, the adhesion strength of the metal-plated film 37 to the main body 32 may be improved due to the coating film 41.

During the manufacture of the base 15a, the primer coating compound is coated on the front surface of the main body 32 which has been molded in the metal mold 38. For example, primer coating compound is sprayed onto the front surface of the main body 32 to form the coating film 41 on the surface of the main body 32. Then, the metal-plated film 37 is formed on the surface of the coating film 41, thereby manufacturing the base 15a. Instead of the coating film 41, the adhesive agent 33 described above may be further applied on the front surface of the main body 32.

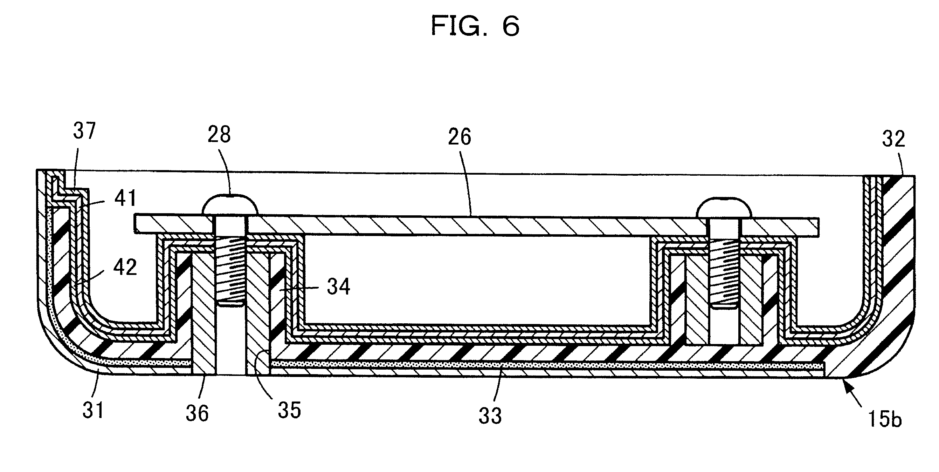

Fig. 6 schematically illustrates a cross-sectional view of a base 15b according to a third embodiment of the invention. The base 15b has a second metal-plated film 42 which is provided between the coating film 41 and the main body 32, in addition to the structure of the base 15a described above. The second metal-plated film 42 extends from the front surface of the main body 32 to one end portion of the front surface of the metal plate 31. At the same time, the second metal-plated film 42 is electrically connected to the metal-plated film 37 described above. The second metal-plated film 42 covers the upper end of the insert members 36. The coating film 41 is surrounded by the metal-plated films 37 and 42. Other components or structures in the base 15b which is similar to the base 15 or the base 15a described above are represented by the same reference numerals.

In the base 15b, the shield performance may be further enhanced due to the metal-plated film 42. At the same time, the metal-plated films 37, 42 and the metal plate 31 can function as a ground member. During the manufacture of the base 15b, the metal-plated film 42 is formed on the front surface of the main body 32 which has been molded in the metal mold 38. The coating film 41 is formed on the surface of the metal-plated film 42. Then, the metal-plated film 37 is formed on the coating film 41, thereby manufacturing the base 15b. Instead of the coating film 41, the adhesive agent 33 described above may be further applied on the metal-plated film 42.

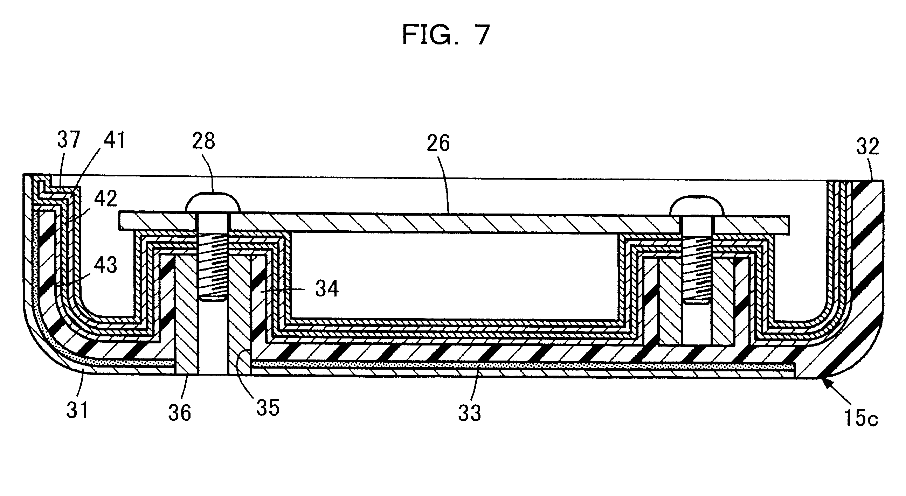

Fig. 7 schematically illustrates a cross-sectional view of a base 15c according to a fourth embodiment of the present invention. The base 15c has a second coating film 43 which is provided between the metal-plated film 42 and the main body 32, in addition to the structure of the base 15b. The coating film 43 is formed on the front surface of the main body 32. The coating film 43 may be formed of the same material as the coating film 41 described above. The metal-plated film 42 is also formed on one end portion of the front surface of the metal plate 31 as in the case of the embodiment described above. At the same time, the metal-plated film 42 is connected to the metal-plated film 37. The metal-plated films 37 and 42 are electrically connected to the insert members 36 and the metal plate 31 through the screws 28. Other components or structures in the base 15c which is similar to the base 15, 15a or 15b described above are represented by the same reference numerals.

According to the base 15c described above, the metal-plated film 42 may be strongly attached to the main body 32 due to the coating film 43. In addition, the shield performance may be further enhanced due to the metal-plated films 37, 42 and the metal plate 31. At the same time, the metal-plated films 37 and 42 and the metal plate 31 may function as a ground member. During the manufacture of the base 15c, the coating film 43, the metal-plated film 42, the coating film 41 and the metal-plated film 37 are formed in sequence on the front surface of the main body 32 which has been molded in the metal mold 38, thereby manufacturing the base 15c. Instead of the coating films 41, 43, the adhesive agent 33 may be applied.

In the bases 15 to 15c according to the embodiments of the present invention as described above, the front surface of the main body 32 may be minutely uneven. For example, irregularities (surface roughness) of about 10 µm may be formed on the front surface of the main body 32. The uneven face of the main body 32 is formed by a pre-treatment. Firstly, the front surface of the main body 32 is degreased or washed with organic solvent or cleaning substance to remove oil or dust thereon. Then, an etching treatment based on plasma, ultraviolet ray, alkali material or acidic material is executed on the front surface of the main body 32. As a result, an uneven face is formed on the front surface of the main body 32. Due to the uneven face of the main body 32, the adhesion strength of the metal-plated films 37, 42 and the coating films 41, 43 with respect to the main body 32 formed of biodegradable resin material may be improved.

The front surface of the metal plate 31 may also be minutely uneven. For example, irregularities (surface roughness) of about 10 µm may be formed on the front surface of the metal plate 31. The uneven face of the metal plate 31 is formed by a pre-treatment. Firstly, the front surface of the metal plate 31 is degreased or washed with organic solvent or cleaning substance to remove oil or dust thereon. Then, an etching treatment based on plasma, ultraviolet ray, alkali material or acidic material is executed on the front surface of the metal plate 31. Alternatively, the front surface of the metal plate 31 may be subjected to oxidation, that is, an activation treatment based on a chemical agent such as phosphoric acid, sulfuric acid, nitric acid, hydrochloric acid, oxalic acid, fluorinated acid, hydrofluoric acid or permanganic acid, whereby the uneven face is formed on the front surface of the metal plate 31. Due to the uneven face of the metal plate 31, the adhesion strength of the adhesive agent 33 and the main body 32 with respect to the metal plate 31 may be enhanced.

Although the main body 32 is formed of biodegradable resin material according to the embodiments described above, the resin material may be plastic formed of at least one of petroleum, mineral, natural gas, oil and fat. Incidentally, the enclosure of the invention may be applied to various applications such as the enclosures of electronic devices such as a personal computer, an information processing terminal (i.e., PDA). Furthermore, the enclosure of the invention may be also applied to parts of vehicles, building materials, parts of home electric appliances, etc.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of embodiments of the invention. Although the embodiments of the present inventions have been described in detail, it should be understood that the various changes, substitutions, and alterations could be made hereto without departing from the scope of the invention.

## Claims

1. An enclosure comprising:
a main body that is formed of resin material;
a metal plate that covers the back surface of the main body;
an adhesive agent that is provided between the main body and the metal plate; and
a metal-plated film that is formed on the front surface of the main body and electrically connected to the metal plate.

2. The enclosure according to claim 1, wherein the metal-plated film extends from the front surface of the main body to the front surface of the metal plate.

3. The enclosure according to claim 1 or 2, wherein the metal plate is provided on the back surface of the main body such that one end portion of the metal plate protrudes outside the main body.

4. The enclosure according to any of claims 1 to 3, wherein a through hole is formed to penetrate through the main body and the metal plate, and
an electrical conducting material is embedded in the through hole, wherein one end portion of the electrical conducting material is connected to the metal-plated film while the other end of the electrical conducting material is connected to the metal plate.

5. The enclosure according to any of claims 1 to 4, further comprising a second adhesive agent that is provided between the metal-plated film and the main body.

6. The enclosure according to any of claims 1 to 5, further comprising a coating film of primer coating compound that is provided between the metal-plated film and the main body.

7. The enclosure according to claim 5, or claim 6 when read as appended to claim 5, further comprising a second metal-plated film that is provided between the main body and the second adhesive agent, wherein the second metal-plated film is electrically connected to the metal plate.

8. The enclosure according to claim 6, or claim 7 when read as appended to claim 6, further comprising a second metal-plated film provided between the main body and the coating film, wherein the second metal-plated film is electrically connected to the metal plate.

9. The enclosure according to any of claims 1 to 8, wherein the main body is formed of biodegradable resin material.

10. The enclosure according to any of claims 1 to 9, wherein the front surface of the main body has a surface roughness of about 10 µm.

11. The enclosure according to any of claims 1 to 10, wherein the front surface of the metal plate has a surface roughness of about 10 µm.

12. A method of manufacturing an enclosure, comprising:
disposing a metal plate in a mold, the front surface of the metal plate being coated with an adhesive agent;
pouring molten resin material into the metal mold;
cooling the resin material within the metal mold to form a main body; and
coating a metal-plated film on the front surface of the main body.
